# DEMANDE DE BREVET EUROPEEN

(11) **EP 0 883 177 A1**
(43) Date de publication de la demande: **09.12.1998**
(21) Numéro de dépôt: 98401286.4
(22) Date de dépôt: 28.05.1998
(51) Int. Cl.: H01L 23/433

(54) **Dispositif semi-conducteur muni d'un dissipateur thermique.**

(30) Priorité: 02.06.1997 FR 9706749
(71) Demandeur: SGS-THOMSON MICROELECTRONICS S.A., 94250 Gentilly (FR)
(72) Inventeur: Moscicki, Jean-Pierre, 38950 Saint-Martin-le-Vinoux (FR)
(74) Mandataire: Casalonga, Axel

(57) **Abrégé**

Dispositif semi-conducteur, comprenant une pastille (2) formant un circuit intégré, une grille de connexion électrique (12) et un dissipateur thermique (6). La face passive de la pastille (2) est fixée par collage sur une face d'appui (10) du dissipateur (6). La grille de connexion présente une ouverture centrale (13a) lui conférant la forme d'un anneau central de grille (13), qui s'étend autour de la pastille et qui est fixé en appui sur ladite face d'appui du dissipateur. L'anneau central de grille (13) est fixé par soudage à ladite face d'appui (10) du dissipateur (6) respectivement en quatre points éloignés des coins de cet anneau central de grille et ladite face d'appui (10) du dissipateur (6) présente des pions de centrage et de fixation (16) en saillie engagés dans des passages traversants (17) de l'anneau central de grille (13).

## Description

La présente invention se rapporte au domaine des dispositifs semi-conducteurs comprenant d'une manière générale, noyés dans un enrobage formant un boîtier, une pastille constituée par un circuit intégré, des fils de connexion électrique reliant la face active de la pastille et une grille de connexion électrique présentant des pattes de connexion électrique débordant à l'extérieur de l'enrobage et constituant des broches de liaison ultérieure par exemple à des pistes d'une plaque de circuit imprimé.

Dans l'état actuel de la technique, la grille de connexion électrique comprend une plaque centrale sur laquelle est fixée par collage la face passive de la pastille formant le circuit intégré, les pattes de connexion précitées étant disposées à la périphérie de cette plaque centrale.

Lorsqu'en particulier la pastille forme un circuit intégré de puissance, il est connu d'y associer un dissipateur thermique pour absorber et dégager la chaleur qu'il produit. Les solutions suivantes ont été proposées.

Une disposition connue consiste à fixer par collage le dissipateur thermique sur la face de la plaque centrale de la grille de connexion électrique opposée à sa face recevant la pastille.

Dans une autre disposition connue, le dissipateur thermique n'est plus fixé par collage mais présente, à ses quatres coins, des pions en saillie qui traversent les coins de la plaque centrale et dont les extrémités situées du côté de la pastille sont serties par écrasement perpendiculairement à la plaque centrale.

Dans une autre disposition connue, le dissipateur thermique n'est pas fixé à la grille de connexion électrique mais on le place dans la cavité basse du moule d'injection de l'enrobage puis on dispose au-dessus et en contact la plaque centrale de la grille de connexion, avant de procéder à l'injection de l'enrobage après fermeture du moule.

Jusqu'à maintenant, les dispositions connues décrites ci-dessus, appliquées à des grands boîtiers, ont donné des résultats relativement satisfaisants en ce qui concerne la dissipation de la chaleur produite.

Cependant, elles se trouvent de plus en plus limitées d'un point de vue capacité de dissipation de la chaleur produite par le circuit intégré et inadaptées d'un point de vue construction et procédé de fabrication lorsqu'il s'agit de fabriquer des dispositifs semi-conducteurs dont les fonctions électroniques augmentent de plus en plus, dont le nombre de connexions augmente de plus en plus et peut atteindre 208 et dont l'encombrement exigé est de plus en plus réduit, comme c'est le cas dans de nombreux systèmes électriques tels que les micro-ordinateurs et les téléphones portables.

La présente invention a pour but de proposer un dispositif semi-conducteur susceptible de présenter une capacité accrue de dissipation de la chaleur produite par le circuit intégré, tout en conservant, voire en améliorant, ses qualités mécaniques et de liaisons électriques.

La présente invention a tout d'abord pour objet un disposititf semi-conducteur comprenant une pastille formant un circuit intégré, une grille de connexion électrique présentant notamment une plaque centrale, ainsi qu'un dissipateur thermique.

Selon l'invention, la face passive de la pastille est fixée, de préférence par collage, sur une face d'appui du dissipateur et ladite plaque centrale de la grille de connexion présente une ouverture centrale lui conférant la forme d'un anneau central de grille, qui s'étend autour de la pastille et qui est fixé en appui sur ladite face d'appui du dissipateur.

Selon l'invention, l'anneau central de grille est fixé de préférence ponctuellement à ladite face d'appui du dissipateur.

Selon l'invention, les branches de cet anneau central de grille sont de préférence fixées, en particulier par soudage, à ladite face d'appui du dissipateur respectivement en un point éloigné des coins de cet anneau central de grille.

Selon l'invention, ladite face d'appui du dissipateur présente avantageusement des pions de centrage et de fixation en saillie engagés dans des passages traversants dudit anneau central de grille.

Selon l'invention, lesdits passages traversants de l'anneau central de grille sont de préférence prévus aux coins de cet anneau et lesdits pions agissent sur l'anneau central de grille vers l'extérieur, sensiblement selon la diagonale correspondante de l'anneau central de grille.

Selon l'invention, les extrémités dépassantes desdits pions sont de préférence déformées vers l'extérieur, sensiblement selon la diagonale correspondante de l'anneau central de grille.

Selon l'invention, lesdits passages traversants de l'anneau central de grille sont de préférence en forme de V ou de U ouverts vers l'intérieur, dont la pointe est dirigée vers l'extérieur sensiblement dans la direction la diagonale correspondante de l'anneau central de grille.

Selon l'invention, lesdits pions sont de préférence de section circulaire.

Selon l'invention, lesdits pions sont de préférence disposés sensiblement à l'intersection des axes des branches correspondantes de l'anneau de grille.

Selon l'invention, ladite face d'appui du dissipateur est dans une variante de forme plane.

Selon l'invention, ladite face d'appui du dissipateur présente, dans une autre variante, un épaulement autour duquel est disposé ledit anneau central de grille.

Selon l'invention, l'épaisseur dudit épaulement est de préférence inférieure ou égale à l'épaisseur de l'anneau central de grille.

Selon l'invention, le bord intérieur de l'anneau central de grille est de préférence situé à distance de la périphérie de la pastille.

Selon l'invention, la face dudit anneau central de grille située du côté du dissipateur est de préférence fixée, par soudage, sur ce dernier.

Selon l'invention, le dissipateur peut avantageusement présenter des évidements latéraux au travers desquels est effectuée la soudure de l'anneau central de grille.

Selon l'invention, l'ouverture centrale dudit anneau central de grille peut être obtenu par découpe ou par poinçonnage, la face par laquelle est réalisé ce poinçonnage étant disposée en appui sur ladite face d'appui du dissipateur.

Selon l invention, le pourtour de ladite face d'appui du dissipateur suit de préférence le pourtour de l'anneau de grille.

Selon l'invention, la grille de connexion peut comprendre en outre des pattes de connexion situées à la périphérie de l'anneau de grille et des fils de connexion dont les extrémités sont sélectivement soudées à la face active de la pastille, de l'anneau de grille et des pattes de connexion, l'ensemble étant noyé dans un enrobage tel que lesdites pattes de connexion débordent à l'extérieur de cet enrobage.

Selon l'invention, la face du dissipateur opposée à sa face d'appui recevant la pastille peut avantageusement déboucher ou affleurer au moins en partie à l'extérieur de l'enrobage.

Selon l'invention, la périphérie de la couche de colle reliant la pastille et le dissipateur est de préférence à distance du bord périphérique intérieur de l'anneau de grille.

Selon l'invention, la colle reliant la pastille et le dissipateur est de préférence en une matière conductrice de l'électricité et de la chaleur.

La présente invention a également pour objet un procédé de fabrication d'un dispostif semi-conducteur de circuit intégré, qui consiste notamment à fixer par collage une pastille formant le circuit intégré sur une face d'appui d'un dissipateur thermique ; à disposer autour et à distance de la pastille un anneau central d'une grille de connexion électrique, en appui sur ladite face d'appui du dissipateur, en engageant des pions de fixation et de centrage prévus en saillie sur la face d'appui du dissipateur au travers de passages traversants de l'anneau de grille prévus dans les coins de cet anneau de grille ; à souder chaque branche de l'anneau de grille sur le dissipateur en un point unique éloigné des coins de cet anneau de grille ; et, dans une étape ultérieure à ce soudage, à sertir la grille de connexion sur le dissipateur par déformation vers l'extérieur desdits pions de fixation et de centrage, sensiblement dans la direction de la diagonale correspondante de l'anneau de grille, de façon à produire une tension dans les branches de l'anneau de grille entre les points de soudage et les pions de fixation et de centrage.

Le procédé selon l'invention consiste en outre à souder de préférence le dissipateur et la face de l'anneau de grille située du côté du dissipateur.

La présente invention sera mieux comprise à l'étude d'un dispositif semi-conducteur comprenant une pastille formant un circuit intégré, une grille de connexion électrique, des fils de connexion électrique, ainsi qu'un dissipateur thermique, noyés dans un enrobage, décrit à titre d'exemple non limitatif et illustré sur lequel :
- la figure 1 représente une vue arrière d'un dispositif semi-conducteur selon l'invention, sans l'enrobage ;
- la figure 2 représente un quart d'une vue avant du dispositif semi-conducteur de la figure 1, sans l'enrobage ;
- la figure 3 représente une coupe médiane partielle selon III-III de la figure 1 du dispositif semi-conducteur précité, avec son enrobage ;
- la figure 4 représente une coupe selon IV-IV de la figure 1 correspondant à une diagonale, du dispositif semi-conducteur précité, avec son enrobage ;
- la figure 5 représente une coupe du dispositif semi-conducteur précité, sans son enrobage, correspondant à la figure 4, montrant une étape de fabrication ;
- les figures 6 et 7 représentent des vues correspondant aux figures 3 et 5 d'une variante d'exécution d'un dispositif semi-conducteur selon l'invention.

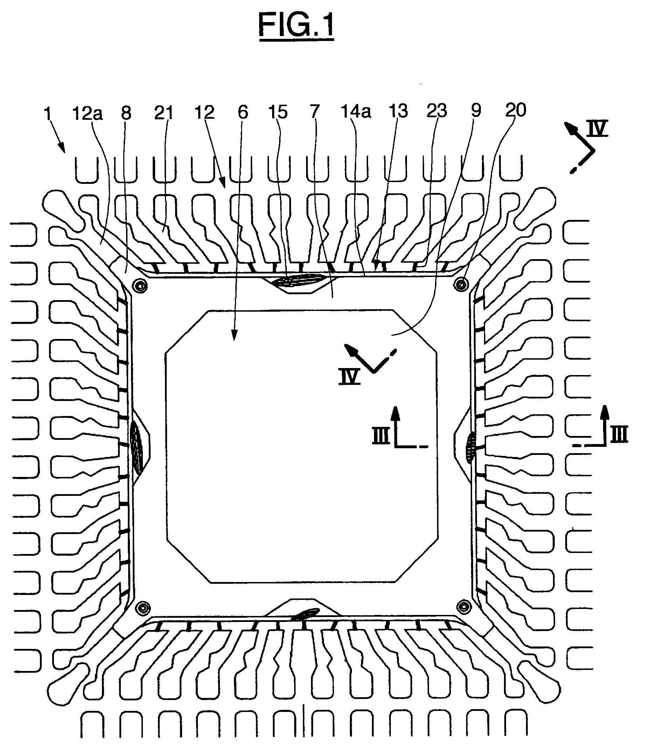

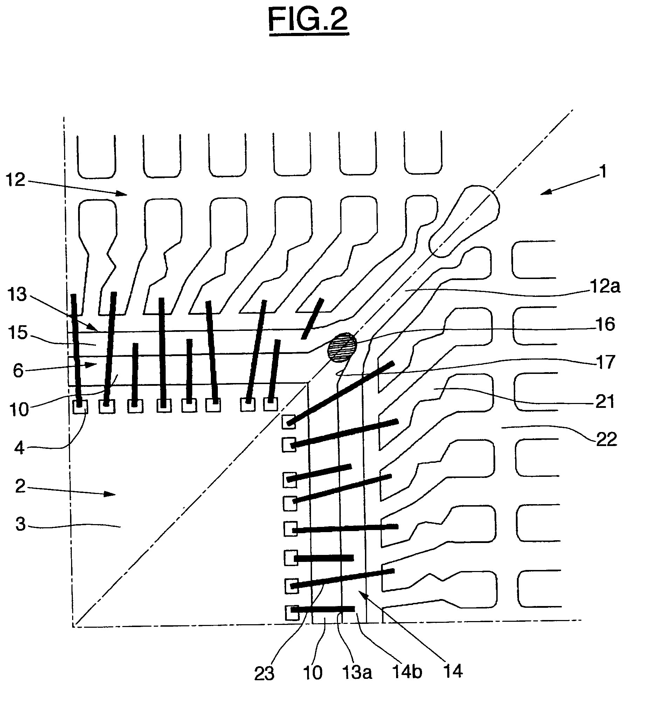

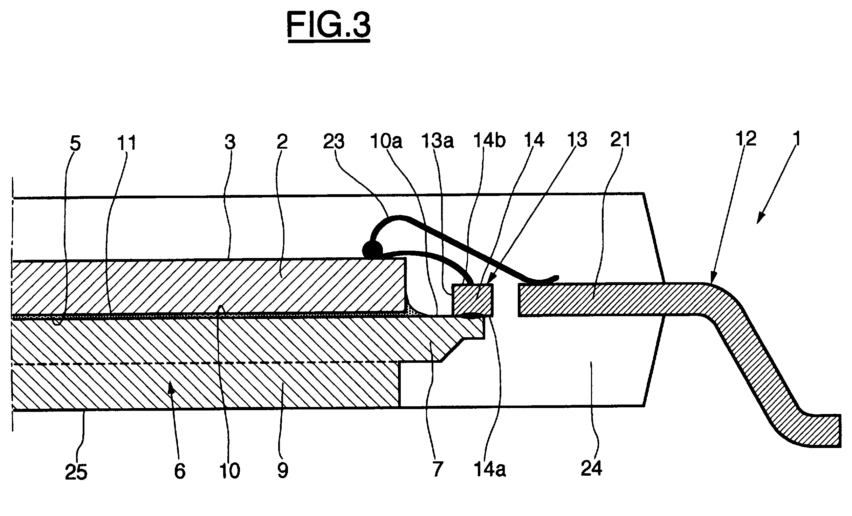

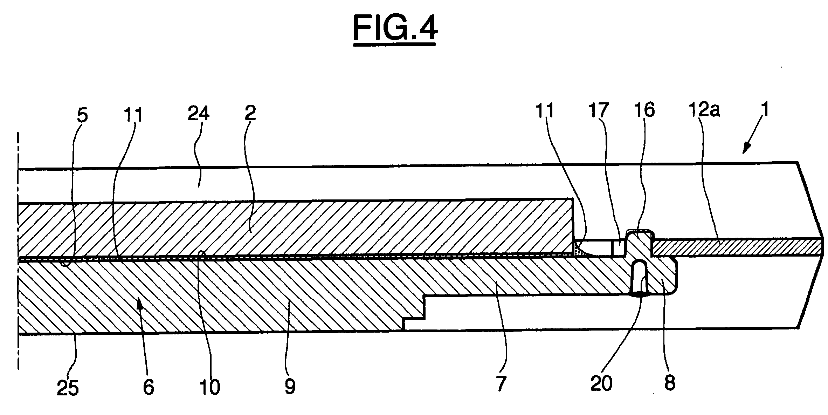

Le dispositif représenté sur les figures 1 à 5, repéré d'une manière générale par la référence 1, comprend une pastille 2 formant un circuit intégré qui, dans l'exemple décrit, est carrée et comprend une face active 3 qui présente le long de ses bords une multiplicité de plots de connexion électrique 4 et, à l'opposé, une face passive 5.

Le dispositif semi-conducteur 1 comprend également un dissipateur thermique 6, par exemple en cuivre, qui se présente sous la forme d'un bloc plat.

Dans l'exemple, ce dissipateur thermique 6 présente une partie avant 7 carrée munie à ses quatre coins de courts prolongements 8 en saillie qui s'étendent selon les diagonales et une partie arrière 9 dont la forme périphérique est réduite par rapport à celle de sa partie avant 7.

La face avant 10 de la partie avant 7 du dissipateur thermique 6 est plate sur toute sa surface et constitue une face d'appui au centre de laquelle est fixée la face passive 5 de la pastille 2, par l'intermédiaire d'une couche mince de colle 11 présentant des qualités de connexion thermiques et électriques.

La face avant d'appui 10 du dissipateur thermique 6 est plus grande que la pastille 2 de manière à ménager, autour de cette dernière, une zone périphérique régulière 10a exempte de colle 11.

Le dispositif semi-conducteur 1 comprend en outre une grille de connexion, repérée d'une manière générale par la référence 12, qui comprend un anneau central de grille 13 qui présente quatre branches 14, deux à deux opposées et parallèles, obtenues par découpe chimique ou par poinçonnage d'une ouverture carrée 13a de la partie centrale d'une plaque centrale grille carrée de la grille 12.

La grille 12 comprend quatre bretelles 12a qui s'étendent selon ses diagonales et qui portent les quatre coins de l'anneau central de grille 13.

La dimension de l'anneau central de grille 13 est telle que ses branches 14 peuvent être disposées en appui sur la zone périphérique d'appui 10a de la face d'appui 10 du dissipateur thermique 6, autour et à distance régulière de la périphérie de la pastille 2.

En fonction des besoins, le bord périphérique de l'anneau central de grille 13 peut être prévu en coincidence avec le bord de la face d'appui du dissipateur thermique 6, ou s'étendre en-deçà ou au-delà. Dans l'exemple réprésenté, l'anneau central de grille 13 déborde légèrement tout autour de la face d'appui 10 du dissipateur thermique 6.

L'anneau central de grille 13 est ponctuellement fixé à la face d'appui 5 du dissipateur thermique 6, au milieu de ses quatre branches 14 et à ses quatre coins de la manière suivante.

Par échauffement par exemple à l'aide d'un laser, les points milieu 15 des faces arrières 14a des quatre branches 14 de l'anneau central de grille 13 sont soudés sur la face d'appui 10 du dissipateur thermique 6. Ainsi, la face avant 14b de l'anneau central de grille 13, rendue soudable par revêtement d'argent, d'or ou de palladium, ne peut pas être abîmée lors de la réalisation de ces soudures 15.

Pour fixer les quatre coins de l'anneau central de grille 13 sur le dissipateur thermique 6, la face d'appui 10 de ce dernier présente quatre pions en saillie 16 de centrage et de fixation, prévus dans la zone des prolongements 8, qui s'étendent au travers de passages traversants 17 ménagés dans les coins de l'anneau central de grille 13, dans les zones d'intersection des axes des bretelles 12a et des branches 14 correspondantes.

Dans l'exemple, les pions 16 sont de section circulaire et les passages traversants 17 sont ouverts vers l'intérieur de l'anneau et présentent la forme d'un U ou d'un V à branches ouvertes vers l'intérieur.

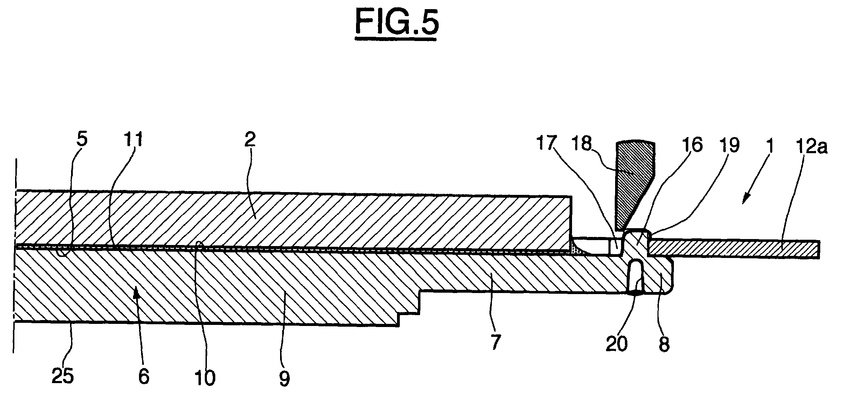

Comme le montre la figure 5, les extrémités des pions 16 sont déformées vers l'extérieur selon les diagonales de l'anneau central de grille 13, par exemple à l'aide d'un outil de sertissage 18, de telle sorte que les pions 16 soient latéralement en appui au fond des passages traversants 17 de l'anneau central de grille 13 et qu'ils présentent une partie 19 débordant vers l'extérieur au-dessus de l'anneau central de grille 13 dans la direction des bretelles 12a.

Ainsi, il se produit avantageusement une tension sensiblement équilibrée dans les portions des branches 14 de l'anneau central de grille 13, respectivement entre les points de soudure 15 et les pions 16 correspondants, ainsi qu'un maintien de l'anneau central de grille 13 contre la face d'appui 10 du dissipateur thermique 6 grâce aux parties débordantes 19 des extrémités des pions 16. Une certaine liberté de mouvement par glissement de l'anneau central de grille 13 sur la face d'appui 10 du dissipateur thermique 6 peut cependant être assurée.

Dans un exemple de réalisation, les pions 16 peuvent être obtenus par emboutissage du dissipateur thermique 6 grâce à un outil non représenté qui provoque des enfoncements 20 dans le dissipateur thermique 6 à l'opposé des pions 16.

La grille de connexion 12 comprend également une multiplicité de pattes de connexion 21 qui s'étendent à la périphérie et à distance de l'annneau central de grille 13, dont les extrémités extérieures sont portées par des bandes périphériques 22 qui portent également les extrémités extérieures des bretelles 12a et qui sont destinées à être ultérieurement séparées.

Le dispositif semi-conducteur 1 comprend en outre une multiplicité de fils de connexion électrique 23 qui relient sélectivement, en fonction des besoins, les plots 4 de la pastille 2, la face avant 14b de l'anneau central de grille 13, et les faces avant des pattes de connexion électriques 21, traitées sur quasiment toutes leurs longueurs de façon à être soudables..

Le dispositif semi-conducteur 1 comprend en outre un enrobage de résine 24, surmoulé de telle sorte que seules les parties d'extrémité extérieures des pattes de connexion électrique 21 débordent à l'extérieur et que la face arrière 25 du dissipateur thermique 6, opposée à sa face d'appui 10, débouche à l'extérieur en affleurant avec sa face arrière.

Pour la fabrication du dispositif semi-conducteur 1 qui vient d'être décrit, on peut procéder de la manière suivante.

On fixe la pastille 2 sur le dissipateur thermique 6 à l'aide de la colle 11. Puis, on réalise l'ensemble des connexions filaires suivantes : pastille 2 vers l'anneau 13, pastille 2 vers les pattes 21 et anneau 13 vers les pattes 21.

Ensuite, on dispose autour et à distance de la pastille l'anneau central de grille 13 en engageant les pions de centrage et de fixation 16 au travers des passages traversants 17 de l'anneau central de grille 13.

Puis, on réalise les quatre points de soudage 15 au milieu des branches 14 de l'anneau central de grille 13.

Dans une étape ultérieure à ce soudage, on sertit par déformation vers l'extérieur les pions 16, dans la direction de la diagonale correspondante de l'anneau central de grille 13.

On dispose l'ensemble ainsi réalisé dans un moule et on injecte la résine d'enrobage 25 qui, après durcissement, constitue un boîtier de semi-conducteur.

Dans une disposition particulièrement avantageuse, il est souhaitable de disposer la grille de connexion 12 dans une position telle que sa face par laquelle est réalisée par poinçonnage l'ouverture centrale 13a de son anneau de grille 13, soit en appui contre la face d'appui 10 du dissipateur thermique 6. Ainsi, la bavure qui peut se produire à l'angle de sa face opposée se trouve à distance de la face d'appui 10 du dissipateur thermique 6 et ne peut en aucun cas nuire au contact entre l'anneau central de grille 13 et cette face d'appui 10.

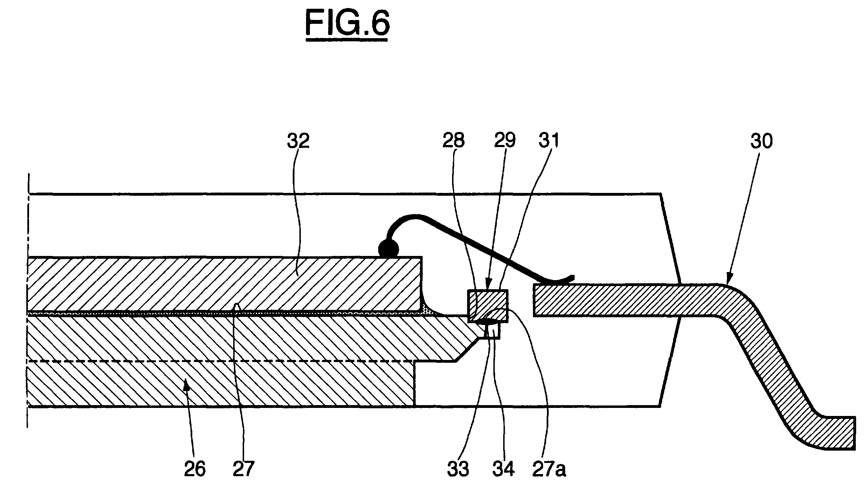

En se reportant maintenant aux figures 6 et 7, on voit que, dans cette variante, la partie périphérique d'un dissipateur thermique 26, par ailleurs identique au dissipateur thermique 6, présente, dans sa face avant d'appui 27, un épaulement périphérique 28 qui délimite une face périphérique avant d'appui 27a en retrait. L'anneau central de grille 29 d'une grille de connexion électrique 30, par exemple identique à la grille de connexion électrique 12, est disposé autour de l'épaulement 28 et en contact sur la face périphérique d'appui 27a.

La hauteur de l'épaulement 28 est telle que la face avant 31 de l'anneau central de grille 29 est au-dessus et à distance de la partie centrale de la face d'appui 27 sur laquelle est fixée la pastille 32. Ainsi, la colle de fixation de la pastille 32 ne peut atteindre cette face avant 31.

Comme dans l'exemple précédent, l'anneau central de grille 29 est fixé par quatre points centraux de soudure 33 sur la face d'appui décalée 27a du dissipateur thermique 26, ce dernier présentant sur sa hauteur des évidements latéraux correspondants 34 facilitant le soudage.

Comme dans l'exemple précédent, la face décalée d'appui 27a du dissipateur thermique 26 présente quatre pions en saillie qui coopèrent avec les coins de l'anneau central de grille 29.

Le dispositif semi-conducteur qui vient d'être décrit est particulièrement adapté pour la réalisation de boîtiers semi-conducteurs de faibles épaisseurs pouvant présenter un nombre important de connexions sur ses quatres côtés, susceptibles de dissiper des puissances thermiques produites par la pastille pouvant aller au moins jusqu'à 5 watts.

Dans un exemple de réalisation, le dissipateur thermique par exemple en cuivre peut présenter une épaisseur comprise entre 0,5 et 0,6 mm. La grille de connexion peut présenter une épaisseur comprise entre 0,12 et 0,15 mm et l'anneau central de grille peut présenter une largeur comprise entre 0,2 et 0,4 mm et et une ouverture centrale de côté compris entre 4 et 12 mm. Les pions 16 peuvent présenter un diamètre compris entre 0,1 et 0,3 mm. La pastille peut présenter une épaisseur comprise entre 0,2 et 0,8 mm et un côté compris entre 3 et 11 mm. La distance entre le bord intérieur de l'anneau central de grille 13 et la périphérie de la pastille 2 peut ainsi être comprise entre 0,2 et 4 mm. Le boîtier peut alors présenter une épaisseur d'environ 1,4 mm et un côté d'environ 14 mm.

Le dispositif semi-conducteur qui vient d'être décrit présente de nombreux avantages.

Grâce au contact direct du dissipateur thermique 6 contre la pastille 2, sur toute la surface de sa face passive 5, uniquement par l'intermédiaire de la couche mince de colle adaptée 11, la dissipation de la chaleur produite par cette pastille est assurée.

La colle 11 ne peut pas venir polluer ni la zone d'appui de l'anneau central de grille 13 sur le dissipateur thermique 6 ni sa face avant 14b sur laquelle sont soudés des fils de connexion électrique. De plus, lors de l'exécution des soudures, l'anneau central de grille 13 est correctement en appui sur la face avant du dissipateur thermique 6.

Grâce aux qualités électriques de la colle 11, la liaison électrique entre la face arrière de la pastille 3 et le dissipateur 6 est assurée.

Le contact entre l'anneau central de grille 13 et la face d'appui 10 du dissipateur thermique 6 est assuré sur toute la périphérie grâce aux points centraux de soudure 15 et aux pions 16 de coin, tout en assurant une certaine liberté de mouvement des parties libres des branches de cet anneau central de grille 13. Cette liberté de mouvement permet d'absorber les contraintes thermo-dynamiques susceptibles d'apparaître d'une part lors de l'injection de l'enrobage 25 qui s'effectue à une température de l'ordre de 185°C et de sa polymérisation et d'autre part lors de l'utilisation ultérieure du boîtier semi-conducteur réalisé, à des températures variables.

La structure proposée permet en outre de quasiment éviter toute délamination entre l'enrobage et d'une part les faces de connexion de la grille de connexion électrique et d'autre part les soudures des fils de connexion, notamment des fils de masse soudés sur l'anneau central de grille 13.

En définitive, le dispositif semi-conducteur proposé permet d'obtenir une dissipation thermique accrue tout en diminuant les risques d'apparition de défauts tels que des craquelures au niveau des soudures des fils de connexion électriques, ainsi les risques de délamination de l'enrobage.

Le dispositif proposé permet la connexion de fils dit de masse sur toute la longueur de chacune des branches de l'anneau. Il permet l'isolement, vis-à-vis des couplages d'impédance entre deux fils véhiculant des signaux à haute fréquence de commutation.

## Revendications

1. Dispositif semi-conducteur, comprenant une pastille (2) formant un circuit intégré, une grille de connexion électrique (12) présentant notamment une plaque centrale, ainsi qu'un dissipateur thermique (6), la face passive de la pastille (2) étant fixée, de préférence par collage, sur une face d'appui (10) du dissipateur et ladite plaque centrale de la grille de connexion présentant une ouverture centrale (13a) lui conférant la forme d'un anneau central de grille (13), qui s'étend autour de la pastille et qui est fixé en appui sur ladite face d'appui du dissipateur, caractérisé par le fait que les branches (14) de l'anneau central de grille (13) sont fixées, de préférence par soudage, à ladite face d'appui (10) du dissipateur (6) respectivement en un point éloigné des coins de cet anneau central de grille et que ladite face d'appui (10) du dissipateur (6) présente des pions de centrage et de fixation (16) en saillie engagés dans des passages traversants (17) de l'anneau central de grille (13) et prévus aux coins de cet anneau, lesdits pions (16) agissant sur l'anneau central de grille vers l'extérieur, sensiblement selon la diagonale correspondante de l'anneau central de grille.

2. Dispostif semi-conducteur selon l'une des revendications 4 et 5, caractérisé par le fait que les extrémités dépassantes desdits pions (16) sont déformées vers l'extérieur, sensiblement selon la diagonale correspondante de l'anneau central de grille (13).

3. Dispostif semi-conducteur selon l'une quelconque des revendications 4 à 6, caractérisé par le fait que lesdits passages traversants (16) de l'anneau central de grille (13) sont en forme de V ou de U ouverts vers l'intérieur, dont la pointe est dirigée vers l'extérieur sensiblement dans la direction la diagonale correspondante de l'anneau central de grille.

4. Dispostif semi-conducteur selon l'une quelconque des revendications 4 à 7, caractérisé par le fait que lesdits pions (16) sont de section circulaire.

5. Dispostif semi-conducteur selon l'une quelconque des revendications 4 à 8, caractérisé par le fait que lesdits pions (16) sont disposés sensiblement au point d'intersection de l'axe des branches (14) correspondantes de l'anneau de grille (13).

6. Dispostif semi-conducteur selon l'une quelconque des revendications précédentes, caractérisé par le fait que ladite face d'appui (10) du dissipateur (6) est de forme plane.

7. Dispostif semi-conducteur selon l'une quelconque des revendications 1 à 9, caractérisé par le fait que ladite face d'appui (27) du dissipateur (26) présente un épaulement périphérique (28) autour duquel est disposé ledit anneau central de grille (29).

8. Dispositif selon la revendication 11, caractérisé par le fait que l''épaisseur dudit épaulement (28) est inférieure ou égale à l'épaisseur de l'anneau central de grille (13).

9. Dispostif semi-conducteur selon l'une quelconque des revendications précédentes, caractérisé par le fait que le bord intérieur (13a) de l'anneau central de grille (13) est situé à distance de la périphérie de la pastille (2).

10. Dispostif semi-conducteur selon l'une quelconque des revendications précédentes, caractérisé par le fait que la face (14a) dudit anneau central de grille (13) située du côté du dissipateur est fixée, de préférence par soudage, sur ce dernier.

11. Dispostif semi-conducteur selon l'une quelconque des revendications précédentes, caractérisé par le fait que le dissipateur (6) présente des évidements latéraux (34) au travers desquels est effectuée la soudure de l'anneau central de grille (13).

12. Dispostif semi-conducteur selon l'une quelconque des revendications précédentes, caractérisé par le fait que l'ouverture centrale (13a) dudit anneau central de grille (13) est obtenu par découpe chimique pour par poinçonnage, la face par laquelle est réalisé ce poinçonnage étant disposée en appui sur ladite face d'appui (10) du dissipateur (6).

13. Dispostif semi-conducteur selon l'une quelconque des revendications précédentes, caractérisé par le fait que le pourtour de ladite face d'appui (10) du dissipateur (6) suit le pourtour de l'anneau central de grille (13).

14. Dispostif semi-conducteur selon l'une quelconque des revendications précédentes, caractérisé par le fait que la grille de connexion (12) comprend en outre des pattes de connexion (21) situées à la périphérie de l'anneau de grille (13) et des fils de connexion (23) dont les extrémités sont sélectivement soudées à la face actice de la pastille, de l'anneau de grille et des pattes de connexion, et qu'il est noyé dans un enrobage (24) tel que lesdites pattes de connexion débordent à l'extérieur de cet enrobage.

15. Dispositif semi-conducteur selon la revendication 18, caractérisé par le fait que la face (25) du dissipateur (6) opposée à sa face d'appui (10) recevant la pastille (2) débouche ou affleure au moins en partie à l'extérieur de l'enrobage (24).

16. Dispositif selon l'une quelconque des revendications précédentes, caractérisé par le fait que la face avant (14b) de l'anneau de grille (13) est traitée de façon à être soudable sur au moins en partie la longueur de ses branches.

17. Dispositif selon l'une quelconque des revendications précédentes, caractérisé par le fait que la périphérie de la couche de colle (11) reliant la pastille (3) et le dissipateur (6) est à distance du bord périphérique intérieur de l'annau de grille (13).

18. Dispositif selon l'une quelconque des revendications précédentes caractérisé par le fait que la colle reliant la pastille (3) et le dissipateur (6) est en une matière conductrice de l'électricité et de la chaleur.

19. Procédé de fabrication d'un dispostif semi-conducteur de circuit intégré, caractérisé par le fait qu'il consiste notamment :
- à fixer par collage une pastille (2) formant le circuit intégré sur une face d'appui (10) d'un dissipateur thermique (6),
- à disposer autour et à distance de la pastille un anneau central (13) d'une grille de connexion électrique (12), en appui sur ladite face d'appui du dissipateur, en engageant des pions de fixation et de centrage (16) prévus en saillie sur la face d'appui du dissipateur au travers de passages traversants (17) de l'anneau central de grille (13) prévus dans les coins de cet anneau,
- à souder chaque branche (14) de l'anneau central (13) de grille sur le dissipateur (6) en un point unique (15) éloigné des coins de cet anneau central de grille,
- et, dans une étape ultérieure à ce soudage, à sertir la grille de connexion sur le dissipateur par déformation vers l'extérieur desdits pions de fixation et de centrage (16), sensiblement dans la direction de la diagonale correspondante de l'anneau central de grille, de façon à produire une tension dans les branches de l'anneau central de grille entre les points de soudage (15) et les pions de fixation et de centrage (16).

20. Procédé selon la revendication 19, caractérisé par le fait qu'il consiste à souder le dissipateur (6) et la face de l'anneau central de grille (13) située du côté du dissipateur (6).
